# EUROPEAN PATENT SPECIFICATION

(11) **EP 3 945 755 B1**
(45) Date of publication and mention of the grant of the patent: **14.06.2023**
(21) Application number: 21175577.2
(22) Date of filing: 25.05.2021
(51) Int. Cl.: H05K 5/00, H05K 7/14

(54) **POWER CONVERTER**
STROMWANDLER
CONVERTISSEUR DE PUISSANCE

(30) Priority: 28.07.2020 JP 2020127245
(43) Date of publication of application: 02.02.2022
(73) Proprietor: Fuji Electric Co., Ltd., Kawasaki-shi, Kanagawa 210-9530 (JP)
(72) Inventor: Adachi, Taketo, Kawasaki-shi, Kanagawa, 210-9530 (JP); Uruma, Tomoki, Kawasaki-shi, Kanagawa, 210-9530 (JP); Yamazawa, Kotaro, Kawasaki-shi, Kanagawa, 210-9530 (JP)
(74) Representative: Appelt, Christian W.

(56) References cited:
- JP-A- 2015 191 434
- JP-B2- 4 274 757

## Description

### BACKGROUND OF THE INVENTION

### Field of the Invention

The present invention relates to a power converter, and more particularly, it relates to a power converter on which an auxiliary board is mounted.

### Description of the Background Art

A power converter on which an auxiliary board is mounted is known in general, as disclosed in JP 4 274757 B2, for example.

A unit device housing (power converter) described in JP 4 274757 B2 includes a resin case main body and a parent cover attached to the resin case main body. The parent cover includes a parent cover basic portion and a parent cover optional portion. A main circuit printed board, which is less frequently replaced, is mounted on the patent cover basic portion. A custom printed board (optional board), which is relatively frequently replaced, is mounted on the parent cover optional portion. Furthermore, a child cover that covers the optional board is attached to the parent cover optional portion. The child cover includes a hole for an indicator light of the optional board. The indicator light of the optional board can be visually recognized from the hole for the indicator light.

Although not clearly described in JP 4 274757 B2, the positions of indicator lights differ from each other depending on the types of optional boards (auxiliary boards). Therefore, when different types of optional boards are arranged in the parent cover optional portion, a separate (dedicated) child cover corresponding to each optional board is required in order to visually recognize each indicator light. Thus, in the conventional unit device housing (power converter) described in JP 4 274757 B2, the types of cover members disadvantageously increase.

JP 2015 191434 A describes a display device comprising: a light-emitting body unit; a display unit provided on a front surface side of the light-emitting body unit and displaying a plurality of display elements that are turned on by transmission of light and that can be visually identified with respect to one another; and a shield member that is disposed on a front surface side of the display unit and that includes shield portions shielding light and transmission portions transmitting light, the transmission portions are each disposed between the adjacent shield portions, one transmission portion contains one or a plurality of display elements in a front view, entirety of the one or plurality of display elements in a state of turning on the one or plurality of display elements are visually recognizable by the one transmission portion in a front view, and at least part of the display elements are shielded by the shield portions and invisible in an oblique view by locating the shield portions in a visual line direction.

### SUMMARY OF THE INVENTION

The present invention has been proposed in order to solve the aforementioned problem, and an object of the present invention is to provide a power converter including a plurality of types of auxiliary boards that can significantly reduce or prevent an increase in the types of cover members.

In order to attain the aforementioned object, a power converter according to an aspect of the present invention includes a power converter main body having a control board provided therein, the power converter main body being configured to allow at least one of a plurality of types of auxiliary boards respectively including indicators to be mounted thereon such that a function is added thereto, a housing configured to house the power converter main body, the housing including a first opening so as to expose the at least one of the plurality of types of auxiliary boards, and a transparent cover member attached to the first opening of the housing. The first opening and the transparent cover member are configured for the indicators of the plurality of types of auxiliary boards in common so as to cover a region of any of the plurality of types of auxiliary boards in which an indicator is arranged even when the any of the plurality of types of auxiliary boards is provided on the power converter main body.

In the power converter according to this aspect of the present invention, as described above, the first opening and the transparent cover member are configured for the indicators of the plurality of types of auxiliary boards in common so as to cover the region of the auxiliary board in which the indicator is arranged even when any of the plurality of types of auxiliary boards is provided on the power converter main body. Accordingly, the indicator of each of the plurality of types of auxiliary boards can be visually recognized through the first opening and the transparent cover member common to the indicators of the plurality of types of auxiliary boards without replacing the cover member so as to correspond to each of the plurality of types of auxiliary boards. Consequently, an increase in the number of types of cover members configured to cover the auxiliary board can be significantly reduced or prevented.

In the aforementioned power converter according to this aspect, the transparent cover member is preferably detachably provided in the first opening. Accordingly, the transparent cover member can be easily replaced.

The aforementioned power converter according to this aspect preferably further includes an operation unit configured to receive an input operation to control the power converter main body, and the first opening is preferably arranged on a surface of the housing on which the operation unit is provided. Accordingly, the operation unit can be easily operated while the state of the indicator is visually recognized through the transparent cover member attached to the first opening.

The aforementioned power converter according to this aspect preferably further includes an opaque sheet member attached to the transparent cover member, and the sheet member preferably includes a second opening at a position that overlaps the indicator as viewed in a direction orthogonal to a surface of the housing on which the first opening is provided. Accordingly, the opaque sheet member is provided such that visual recognition of the inside (auxiliary board) of the housing from the outside can be significantly reduced or prevented. Furthermore, the second opening is provided at the position that overlaps the indicator as viewed in the direction orthogonal to the surface of the housing on which the first opening is provided such that the state of the indicator can be visually recognized through the second opening while visual recognition of the inside (auxiliary board) of the housing from the outside is prevented.

In this case, the sheet member preferably includes a seal member (8, 18) affixed to the transparent cover member. Accordingly, the sheet member (seal member) can be easily attached to the transparent cover member.

In the aforementioned power converter including the sheet member, the sheet member is preferably attached to a surface (7a) of the transparent cover member on a side opposite to an auxiliary board side. Accordingly, the sheet member can be replaced without removing the transparent cover member.

In this case, the indicator preferably includes a light emitter configured to emit light toward the transparent cover member, the power converter preferably further comprises a light-shielding member provided between the transparent cover member and the at least one of the plurality of types of auxiliary boards, and the light-shielding member preferably includes a third opening at a position that overlaps the second opening of the sheet member as viewed in the direction orthogonal to the surface of the housing on which the first opening is provided. Accordingly, the light-shielding member including the third opening is arranged between the transparent cover member and the auxiliary board such that light emitted from the light emitter in an oblique direction with respect to a direction perpendicular to an opening surface of the third opening can be shielded by the light-shielding member. Consequently, mixing of light from adjacent light emitters and emission of the mixed light through the third opening can be significantly reduced or prevented.

In the aforementioned power converter including the light-shielding member, the transparent cover member preferably includes a holder configured to hold the light-shielding member on the auxiliary board side. Accordingly, the light-shielding member can be held by the holder of the transparent cover member without providing a mechanism configured to hold the light-shielding member separately from the cover member in the housing or the like, and thus the configuration of the housing or the like can be simplified.

In the aforementioned power converter including the light-shielding member, the light-shielding member preferably includes the light-shielding member for each of the plurality of types of auxiliary boards, the light-shielding member including the third opening so as to correspond to a position of the light emitter provided on each of the plurality of types of auxiliary boards. Accordingly, the light-shielding member corresponding to each of the plurality of types of auxiliary boards is used such that light from the light emitter can be reliably visually recognized through the third opening, and thus the light from the light emitter can be visually recognized without replacing the cover member for each auxiliary board.

In the aforementioned power converter including the sheet member, the sheet member preferably includes a character described in a vicinity of the second opening, the character indicating a content displayed by the indicator. Accordingly, even when the auxiliary board cannot be directly visually recognized from the outside due to the sheet member, the content displayed by the indicator can be confirmed by visually recognizing the character described on the sheet member.

In the aforementioned power converter including the sheet member, the sheet member preferably includes the sheet member for each of the plurality of types of auxiliary boards, the sheet member including the second opening so as to correspond to a position of the indicator provided on each of the plurality of types of auxiliary boards. Accordingly, the sheet member corresponding to each of the plurality of types of auxiliary boards is used such that the indicator can be visually recognized through the second opening, and thus the indicator can be visually recognized without replacing the cover member for each auxiliary board.

The foregoing and other objects, features, aspects and advantages of the present invention will become more apparent from the following detailed description of the present invention when taken in conjunction with the accompanying drawings.

### BRIEF DESCRIPTION OF THE DRAWINGS

FIG. 1 is a front view showing the configuration of a power converter according to an embodiment;
FIG. 2 is a perspective view showing the configuration of the power converter according to the embodiment;
FIG. 3 is a diagram showing a mounting mechanism of a mounting mechanism of a transparent cover member of the power converter according to the embodiment;
FIG. 4 is a partial enlarged view showing a configuration in the vicinity of an opening of a housing of the power converter according to the embodiment;
FIG. 5 is a partial enlarged view showing the configuration of a seal member of the power converter according to the embodiment;
FIG. 6 is a partial enlarged view of the vicinity of a hole provided in the seal member of the power converter according to the embodiment;
FIG. 7 is a sectional view showing the configuration of the transparent cover member, the seal member, and a light-shielding member of the power converter according to the embodiment;
FIG. 8 is a partial enlarged view of the vicinity of a holder of the transparent cover member of FIG. 7;
FIG. 9 is a sectional view showing the configuration of a transparent cover member, a seal member, and a light-shielding member of a power converter according to a modified example of the embodiment;

### DESCRIPTION OF THE PREFERRED EMBODIMENTS

An embodiment of the present invention is hereinafter described with reference to the drawings.

### [This Embodiment]

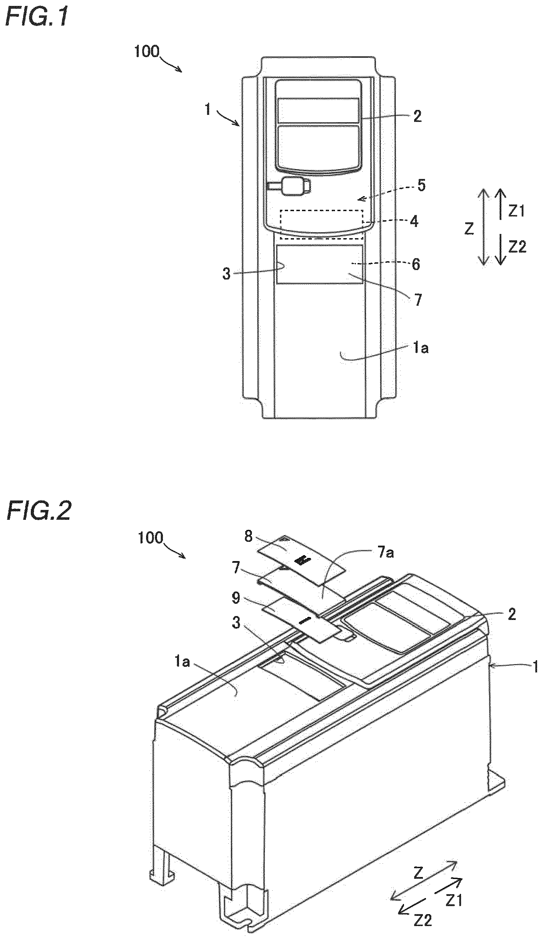

The configuration of a power converter 100 according to this embodiment is now described with reference to FIGS. 1 to 8.

The power converter 100 is an inverter device applied to a variable speed motor drive system, for example. This inverter device is a typical device of a power electronics device that converts electricity into a desired shape by the switching operation of a power semiconductor element. This variable speed motor drive system can drive a motor with high efficiency and high accuracy by changing a voltage, a current, and a frequency supplied to the motor to desired values with the inverter device.

The inverter device applied to the variable speed motor drive system is roughly classified into an inverter device optimized as a pair with a motor and a general-purpose inverter device used in various applications. In the case of a general-purpose inverter device, an applied motor is different, and the application is various such that the general-purpose inverter device has many functions, and it is common that a function is selected and used according to a system that a customer desires to achieve. In order to accommodate various customers and applications, functions that are not incorporated in the standard inverter device are achieved by adding an optional card (an auxiliary board 6 described below) designed for each function.

### (Configuration of Power Converter)

As shown in FIG. 1, the power converter 100 includes a housing 1. The housing 1 has a box shape.

An operation panel 2 is provided on the front surface 1a of the housing 1. The operation panel 2 is configured to receive an input operation for controlling a power converter main body 5 described below. A predetermined operation (command input) is performed on a screen of the operation panel 2 such that which of a plurality of types of auxiliary boards 6 described below is arranged in the power converter 100 can be displayed on the screen of the operation panel 2. The operation panel 2 and the front surface 1a are examples of an "operation unit" and a "surface" in the claims, respectively.

The power converter 100 (housing 1) is arranged such that the front surface 1a of the housing 1 is orthogonal to the floor surface (not shown).

The housing 1 includes an opening 3. The opening 3 is provided to expose an auxiliary board 6 described below. The opening 3 is an example of a "first opening" in the claims.

In this embodiment, the opening 3 is arranged on the front surface 1a of the housing 1 on which the operation panel 2 is provided. Specifically, the opening 3 is provided below the operation panel 2 (Z2 side) on the front surface 1a of the housing 1.

The power converter 100 includes the power converter main body 5 in which a control board 4 is provided. The power converter main body 5 is housed in the housing 1. Each of the control board 4 and the auxiliary board 6 described below is a printed board.

The power converter main body 5 is configured such that the plurality of types (ten types, for example) of auxiliary boards 6 can be mounted thereon. The power converter main body 5 is configured such that a function (corresponding to the mounted auxiliary board 6) is added by mounting at least one of the plurality of types of auxiliary boards 6 thereon. That is, the auxiliary board 6 mounted on the power converter main body 5 is replaced such that the power converter 100 can change a function added to the power converter main body 5. In this embodiment, an example in which one auxiliary board 6 is mounted on the power converter main body 5 at a time is described, but a plurality of auxiliary boards 6 may be arranged side by side on the power converter main body 5. In this case, one transparent cover member 7 (opening 3), which is described below, common to the auxiliary boards 6 arranged side by side is provided.

The auxiliary board 6 is fixed to the housing 1 (power converter main body 5) by a claw (not shown) and a screw (not shown). On a surface of the auxiliary board 6, a knob for extraction (not shown) is provided.

The auxiliary board 6 includes an auxiliary board for communication, for example. The auxiliary board for communication enables communication made by synchronous operation, for example, which is not supported by the standard power converter 100 (inverter device).

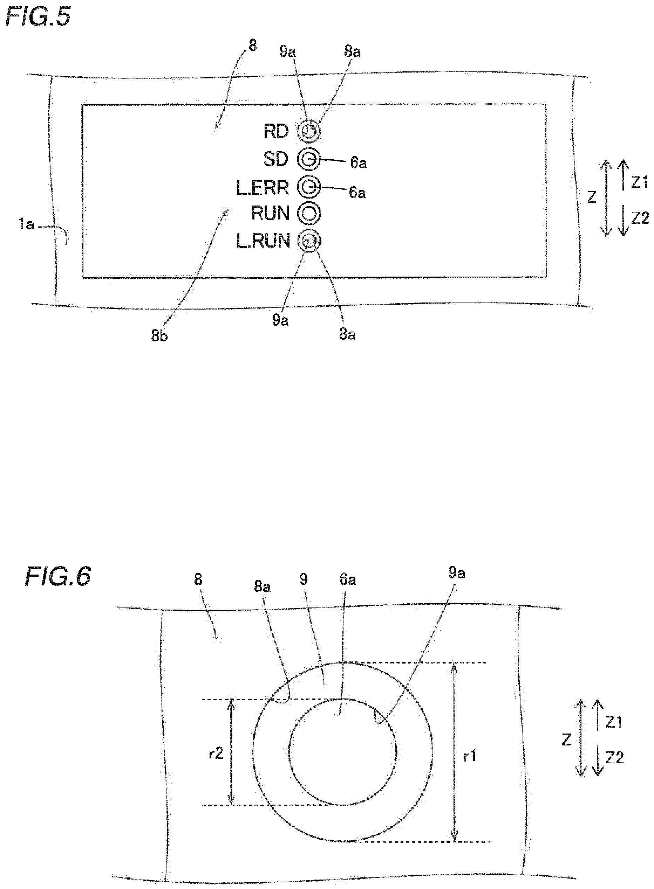

Each of the plurality of types of auxiliary boards 6 includes indicators 6a (see FIG. 5). The indicators 6a are configured to emit light toward the transparent cover member 7 described below. For example, the indicators 6a include LEDs. The indicators 6a have a role of indicating the state (the communication state, for example) of the auxiliary board 6. For example, when emitting green light, the indicators 6a indicate that the communication state of the auxiliary board 6 is normal (in the process of communication), and when emitting red light, the indicators 6a indicate that the state of the auxiliary board 6 is abnormal (communication is disconnected). The indicators 6a are examples of a "light emitter" in the claims.

The power converter 100 includes the transparent cover member 7 attached to the opening 3 of the housing 1. The transparent cover member 7 has a substantially rectangular shape as viewed in a direction orthogonal to the front surface 1a of the housing 1.

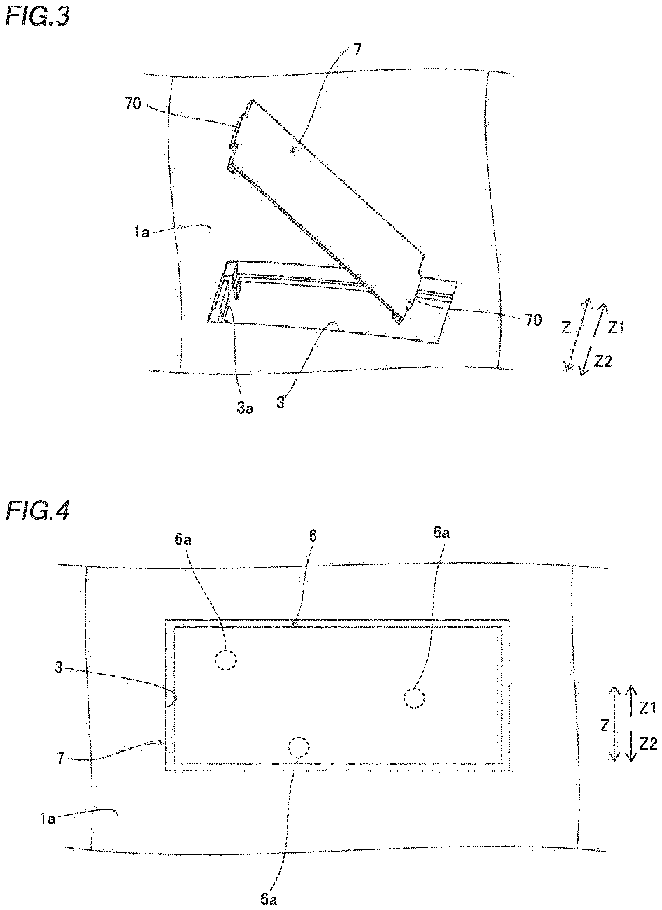

In this embodiment, the transparent cover member 7 is detachably provided in the opening 3. Specifically, snaps 70 (see FIG. 3) provided in the cover member 7 engages with engaging portions 3a provided in the opening 3 (housing 1) such that the cover member 7 is fitted (fixed) into the opening 3. The snaps 70 are provided at both ends of the transparent cover member 7 in a longitudinal direction. The snaps 70 disengage from the engaging portions 3a such that the transparent cover member 7 is removed from the opening 3. The cover member 7 is made of polycarbonate, for example. Polycarbonate has transparency and flexibility, and has higher impact resistance than an acrylic plate or the like. Except for FIG. 3, the snaps 70 and the engaging portions 3a are not shown for the sake of simplicity.

In this embodiment, as shown in FIG. 4, the opening 3 and the transparent cover member 7 are configured for the indicators 6a of the plurality of types of auxiliary boards 6 in common so as to cover a region of the auxiliary board 6 in which the indicators 6a are arranged even when any type of auxiliary board 6 is provided on the power converter main body 5. In other words, even when any type of auxiliary board 6 is provided on the power converter main body 5, the indicators 6a of the auxiliary board 6 are provided so as to be exposed from the common (single) opening 3.

In FIG. 4, the positions of the indicators 6a in a case in which each of the auxiliary boards 6 different from each other is arranged on the power converter main body 5 are shown by broken lines. That is, the three indicators 6a of FIG. 4 are provided on the auxiliary boards 6 different from each other. The indicators 6a are provided inside the common (single) opening 3 whereas the positions thereof are different from each other. The entire auxiliary board 6 provided on the power converter main body 5 is provided so as to be exposed from the opening 3.

As shown in FIG. 2, the power converter 100 includes an opaque seal member 8 attached (affixed) to the transparent cover member 7. The seal member 8 is colored in the same color as the housing 1 in order to improve the aesthetic appearance of the power converter 100 (housing 1). In FIG. 4, the seal member 8 is not shown for the sake of simplicity. The seal member 8 is an example of a "sheet member" in the claims.

As shown in FIG. 5, the seal member 8 has a size substantially equal to that of the transparent cover member 7 as viewed in the direction orthogonal to the front surface 1a on which the opening 3 of the housing 1 is provided.

In this embodiment, the seal member 8 is affixed to a surface 7a (see FIG. 2) of the transparent cover member 7 on the side opposite to the auxiliary board 6 side. Therefore, in the transparent cover member 7, a region other than regions corresponding to openings 8a described below of the seal member 8 is covered with the seal member 8.

In this embodiment, as shown in FIG. 5, the seal member 8 includes the openings 8a at positions that overlap the indicators 6a as viewed in the direction orthogonal to the front surface 1a of the housing 1 on which the opening 3 is provided. That is, the indicators 6a can be visually recognized through the openings 8a. The openings 8a are examples of a "second opening" in the claims.

Specifically, when a plurality of indicators 6a are provided on the auxiliary board 6, the seal member 8 includes an individual opening 8a for each of the plurality of indicators 6a. The openings 8a each have a substantially circular shape as viewed in the direction orthogonal to the front surface 1a.

In this embodiment, the seal member 8 includes a seal member 8 for each type of auxiliary board 6 including the openings 8a so as to correspond to the positions of the indicators 6a provided on each of the plurality of types of auxiliary boards 6. That is, each of the plurality of types of auxiliary boards 6 has a corresponding dedicated seal member 8. Thus, the corresponding seal member 8 is affixed to the transparent cover member 7 according to the type of the auxiliary board 6 provided on the power converter main body 5 such that the indicators 6a of the auxiliary board 6 become visible from the openings 8a of the seal member 8.

In this embodiment, characters 8b indicating the contents displayed by the indicators 6a are described in the vicinity of the openings 8a in the seal member 8. In an example shown in FIG. 5, the seal member 8 has "RD", "SD", "L.ERR", "RUN", and "L.RUN" on the left sides of the openings 8a, respectively, in order from the opening 8a on the Z1 side. The characters 8b described on the seal member 8 are different from each other depending on the seal member 8 (depending on the corresponding auxiliary board 6).

The state of the auxiliary board 6 is represented by the combination of the lighting states of the above five indicators 6a. As an example, when the indicator 6a corresponding to L.ERR is turned off, and the four indicators 6a corresponding to the characters 8b other than L.ERR are turned on, the auxiliary board 6 is in normal operation (in the process of communication).

As shown in FIG. 2, the power converter 100 includes a light-shielding member 9 provided between the transparent cover member 7 and the auxiliary board 6. The light-shielding member 9 has a substantially rectangular shape as viewed from the front surface 1a of the housing 1, similarly to the transparent cover member 7 and the seal member 8. The light-shielding member 9 is made of paper. The light-shielding member 9 may be made of a material other than paper (made of resin, for example) as long as the same has a light-shielding property.

In this embodiment, as shown in FIG. 5, the light-shielding member 9 includes openings 9a at positions that overlap the openings 8a of the seal member 8 as viewed in the direction orthogonal to the front surface 1a of the housing 1 on which the opening 3 is provided. That is, the openings 9a are provided at positions that overlap the openings 8a and the indicators 6a as viewed in the direction orthogonal to the front surface 1a of the housing 1 on which the opening 3 is provided. The openings 9a are examples of a "third opening" in the claims.

The openings 9a of the light-shielding member 9 each have a substantially circular shape, similarly to the openings 8a of the seal member 8. The openings 9a are surrounded by the openings 8a as viewed in the direction orthogonal to the front surface 1a. That is, the diameter r1 (see FIG. 6) of each of the openings 8a is larger than the diameter r2 (see FIG. 6) of each of the openings 9a.

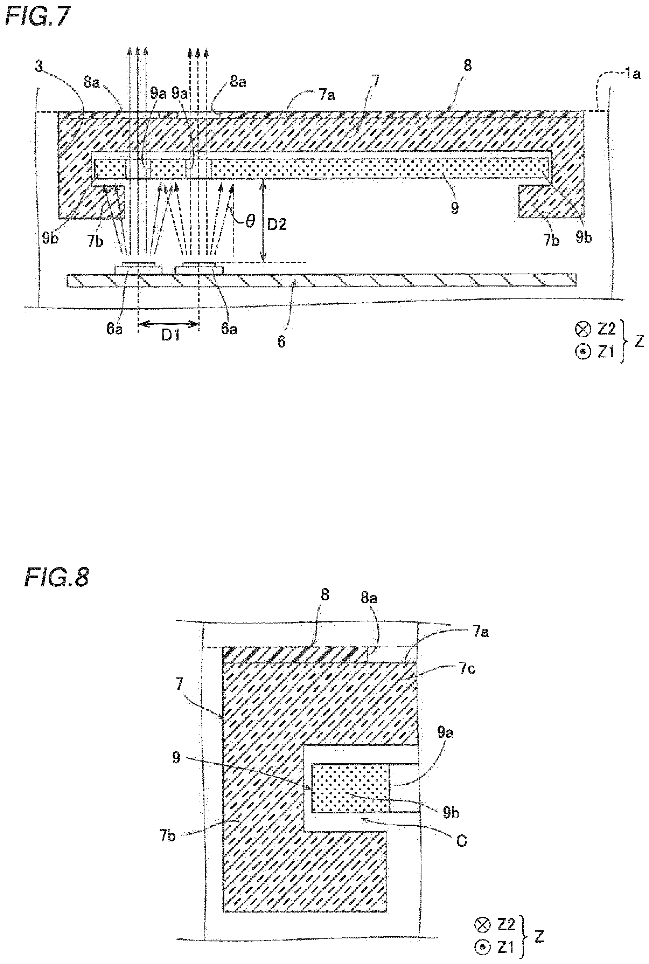

As shown in FIG. 7, the diameter r2 (see FIG. 6) of each of the openings 9a of the light-shielding member 9 is set such that light emitted from another indicator 6a adjacent to an indicator 6a does not enter the opening 9a corresponding to the indicator 6a. Specifically, the diameter r2 is set based on a distance D1 between the indicators 6a adjacent to each other, a distance D2 between the indicators 6a and the light-shielding member 9, and the maximum angle θ of light emitted from the indicator 6a with respect to the direction orthogonal to the front surface 1a. In FIG. 7, for convenience of description, the arrangement of the indicators 6a is different from that in FIG. 6 etc.

In this embodiment, the light-shielding member 9 includes a light-shielding member 9 for each type of auxiliary board 6 including the openings 9a so as to correspond to the positions of the indicators 6a provided on each of the plurality of types of auxiliary boards 6. That is, each of the plurality of types of auxiliary boards 6 has a corresponding dedicated light-shielding member 9. Thus, the corresponding light-shielding member 9 is provided according to the type of the auxiliary board 6 provided on the power converter main body 5 such that the indicators 6a of the auxiliary board 6 become visible from the openings 9a of the light-shielding member 9.

In this embodiment, holders 7b configured to hold the light-shielding member 9 are provided on the auxiliary board 6 side of the transparent cover member 7. The holders 7b are provided so as to hold both ends 9b in the longitudinal direction of the light-shielding member 9 having a substantially rectangular shape.

Specifically, as shown in FIG. 8, the transparent cover member 7 includes a front surface portion 7c provided with the surface 7a (see FIG. 2) of the transparent cover member 7. The holders 7b protrude from the front surface portion 7c toward the auxiliary board 6, and ends thereof on the auxiliary board 6 side (the lower side in FIG. 8) are folded back toward the center side of the light-shielding member 9 such that the holders 7b each have a substantially L-shape. The ends of the holders 7b folded back toward the center of the light-shielding member 9 are provided so as to extend in parallel to the front surface portion 7c. Thus, the ends 9b of the light-shielding member 9 are fixed by being inserted into clearances C surrounded by the front surface portion 7c and the holders 7b of the transparent cover member 7.

### (Advantageous Effects of This Embodiment)

According to this embodiment, the following advantageous effects are achieved.

According to this embodiment, as described above, in the power converter 100, the opening 3 and the transparent cover member 7 are configured for the indicators 6a of the plurality of types of auxiliary boards 6 in common so as to cover the region of the auxiliary board 6 in which the indicators 6a are arranged even when any type of auxiliary board 6 is provided on the power converter main body 5. Accordingly, the indicators 6a of each of the plurality of types of auxiliary boards 6 can be visually recognized through the opening 3 and the transparent cover member 7 common to the indicators 6a of the plurality of types of auxiliary boards 6 without replacing the cover member 7 so as to correspond to each of the plurality of types of auxiliary boards 6. Consequently, an increase in the number of types of cover members configured to cover the auxiliary board 6 can be significantly reduced or prevented.

According to this embodiment, as described above, in the power converter 100, the transparent cover member 7 is detachably provided in the opening 3. Accordingly, the transparent cover member 7 can be easily replaced. Furthermore, the cover member 7 is removed such that the seal member 8 and the light-shielding member 9 can be replaced together with replacement of the auxiliary board 6.

According to this embodiment, as described above, in the power converter 100, the opening 3 is arranged on the front surface 1a of the housing 1 on which the operation panel 2 is provided. Accordingly, the operation panel 2 can be easily operated while the states of the indicators 6a are visually recognized through the transparent cover member 7 attached to the opening 3.

According to this embodiment, as described above, in the power converter 100, the openings 8a are provided at the positions of the seal member 8 that overlap the indicators 6a as viewed in the direction orthogonal to the front surface 1a of the housing 1 on which the opening 3 is provided. Accordingly, the opaque seal member 8 is provided such that visual recognition of the inside (auxiliary board 6) of the housing 1 from the outside can be significantly reduced or prevented. Furthermore, the openings 8a are provided at the positions that overlap the indicators 6a as viewed in the direction orthogonal to the front surface 1a of the housing 1 on which the opening 3 is provided such that the states of the indicators 6a can be visually recognized through the openings 8a while visual recognition of the inside (auxiliary board 6) of the housing 1 from the outside is prevented.

According to this embodiment, as described above, in the power converter 100, the seal member 8 includes the seal member 8 affixed to the transparent cover member 7. Accordingly, the seal member 8 can be easily attached to the transparent cover member 7.

According to this embodiment, as described above, in the power converter 100, the seal member 8 is attached to the surface 7a of the transparent cover member 7 on the side opposite to the auxiliary board 6 side. Accordingly, the seal member 8 can be replaced without removing the transparent cover member 7.

According to this embodiment, as described above, in the power converter 100, the openings 9a are provided at the positions of the light-shielding member 9 that overlap the openings 8a of the seal member 8 as viewed in the direction orthogonal to the front surface 1a of the housing 1 on which the opening 3 is provided. Accordingly, the light-shielding member 9 including the openings 9a is arranged between the transparent cover member 7 and the auxiliary board 6 such that light emitted from the indicators 6a in an oblique direction with respect to a direction perpendicular to opening surfaces of the openings 9a can be shielded by the light-shielding member 9. Consequently, mixing of light from adjacent indicators 6a and emission of the mixed light through the openings 9a can be significantly reduced or prevented.

According to this embodiment, as described above, in the power converter 100, the holders 7b configured to hold the light-shielding member 9 are provided on the auxiliary board 6 side of the transparent cover member 7. Accordingly, the light-shielding member 9 can be held by the holders 7b of the transparent cover member 7 without providing a mechanism configured to hold the light-shielding member 9 separately from the cover member 7 in the housing 1 or the like, and thus the configuration of the housing 1 or the like can be simplified.

According to this embodiment, as described above, in the power converter 100, the light-shielding member 9 includes the light-shielding member 9 for each type of auxiliary board 6 including the openings 9a so as to correspond to the positions of the indicators 6a provided on each of the plurality of types of auxiliary boards 6. Accordingly, the light-shielding member 9 corresponding to each type of auxiliary board 6 is used such that light from the indicators 6a can be reliably visually recognized through the openings 9a, and thus the light from the indicators 6a can be visually recognized without replacing the cover member 7 for each auxiliary board 6.

According to this embodiment, as described above, in the power converter 100, the characters 8b indicating the contents displayed by the indicators 6a are described in the vicinity of the openings 8a in the seal member 8. Accordingly, even when the auxiliary board 6 cannot be directly visually recognized from the outside due to the seal member 8, the contents displayed by the indicators 6a can be confirmed by visually recognizing the characters 8b described on the seal member 8.

According to this embodiment, as described above, in the power converter 100, the seal member 8 includes the seal member 8 for each type of auxiliary board 6 including the openings 8a so as to correspond to the positions of the indicators 6a provided on each of the plurality of types of auxiliary boards 6. Accordingly, the seal member 8 corresponding to each type of auxiliary board 6 is used such that the indicators 6a can be visually recognized through the openings 8a, and thus the indicators 6a can be visually recognized without replacing the cover member 7 for each auxiliary board 6.

### [Modified Examples]

The embodiment disclosed this time must be considered as illustrative in all points and not restrictive. The scope of the present invention is not shown by the above description of the embodiment but by the scope of claims for patent, and all modifications (modified examples) within the meaning and scope equivalent to the scope of claims for patent are further included.

For example, while the transparent cover member 7 is detachably provided in the opening 3 (first opening) in the aforementioned embodiment, the present invention is not restricted to this. The transparent cover member 7 may alternatively be fixed to the opening 3 in a non-removable state.

While the opening 3 (first opening) is arranged on the front surface 1a (surface) of the housing 1 on which the operation panel 2 (operation unit) is provided in the aforementioned embodiment, the present invention is not restricted to this. The opening 3 may alternatively be arranged on a surface of the housing 1 different from the front surface 1a of the housing 1 on which the operation panel 2 is provided.

While the seal member 8 is affixed to the transparent cover member 7 in the aforementioned embodiment, the present invention is not restricted to this. A member other than the seal member may alternatively be attached to the transparent cover member 7 as long as the same is a sheet-shaped member configured to cover the transparent cover member 7.

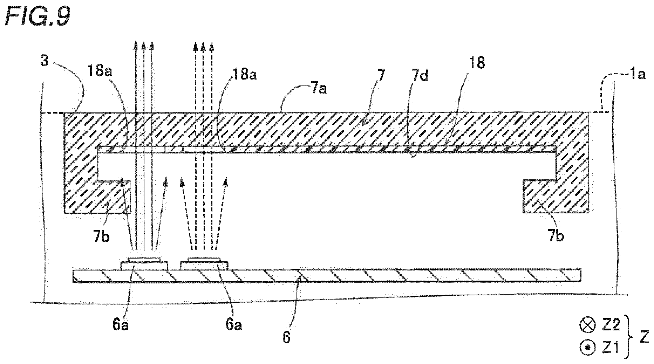

While the seal member 8 (sheet member) is affixed to the surface 7a of the transparent cover member 7 opposite to the auxiliary board 6 in the aforementioned embodiment, the present invention is not restricted to this. For example, the seal member may alternatively be affixed to a surface opposite to the surface 7a. Specifically, as shown in FIG. 9, a seal member 18 is affixed to a rear surface 7d of a transparent cover member 7 on the auxiliary board 6 side. The seal member 18 includes openings 18a provided at positions that overlap indicators 6a as viewed in a direction orthogonal to a front surface of a housing 1. In this case, it is not necessary to provide a light-shielding member 9 shown in the embodiment described above. The seal member 18 and the openings 18a are examples of a "sheet member" and a "second opening" in the claims, respectively.

While the holders 7b configured to hold the light-shielding member 9 are provided in the transparent cover member 7 in the aforementioned embodiment, the present invention is not restricted to this. For example, holders configured to hold the light-shielding member 9 may alternatively be provided in the housing 1.

While each of the seal member 8 (sheet member) and the light-shielding member 9 is a member provided exclusively for each type of auxiliary board 6 in the aforementioned embodiment, the present invention is not restricted to this. For example, a common seal member 8 and a common light-shielding member 9 may alternatively be used for different types of auxiliary boards 6 having the same arrangement of the indicators 6a.

While the operation panel 2 for operating the power converter main body 5 is provided in the aforementioned embodiment, the present invention is not restricted to this. For example, a touch panel operation unit may alternatively be provided. Furthermore, the operation panel 2 may alternatively be removable.

While the transparent cover member 7 is applied to the housing 1 in the aforementioned embodiment, the present invention is not restricted to this. When an opening to which the transparent cover member 7 is attached is provided, the transparent cover member 7 can be applied in common in power converters having different capacities (power converters having different sizes of housings).

## Claims

1. A power converter (100) comprising:
a power converter main body (5) having a control board (4) provided therein, the power converter main body being configured to allow at least one of a plurality of types of auxiliary boards (6) respectively including indicators (6a) to be mounted thereon such that a function is added thereto;
a housing (1) configured to house the power converter main body, the housing including a first opening (3) so as to expose the at least one of the plurality of types of auxiliary boards; and
a transparent cover member (7) attached to the first opening of the housing; wherein
the first opening and the transparent cover member are configured for the indicators of the plurality of types of auxiliary boards in common so as to cover a region of any of the plurality of types of auxiliary boards in which an indicator is arranged even when the any of the plurality of types of auxiliary boards is provided on the power converter main body.

2. The power converter according to claim 1, wherein the transparent cover member is detachably provided in the first opening.

3. The power converter according to claim 1 or 2, further comprising:
an operation unit (2) configured to receive an input operation to control the power converter main body; wherein
the first opening is arranged on a surface (1a) of the housing on which the operation unit is provided.

4. The power converter according to any one of claims 1 to 3, further comprising:
an opaque sheet member (8, 18) attached to the transparent cover member; wherein
the sheet member includes a second opening (8a, 18a) at a position that overlaps the indicator as viewed in a direction orthogonal to a surface of the housing on which the first opening is provided.

5. The power converter according to claim 4, wherein the sheet member includes a seal member (8, 18) affixed to the transparent cover member.

6. The power converter according to claim 4 or 5, wherein the sheet member (8) is attached to a surface (7a) of the transparent cover member on a side opposite to an auxiliary board side.

7. The power converter according to claim 6, wherein
the indicator includes a light emitter (6a) configured to emit light toward the transparent cover member;
the power converter further comprises a light-shielding member (9) provided between the transparent cover member and the at least one of the plurality of types of auxiliary boards; and
the light-shielding member includes a third opening (9a) at a position that overlaps the second opening of the sheet member as viewed in the direction orthogonal to the surface of the housing on which the first opening is provided.

8. The power converter according to claim 7, wherein the transparent cover member includes a holder (7b) configured to hold the light-shielding member on the auxiliary board side.

9. The power converter according to claim 7 or 8, wherein the light-shielding member includes the light-shielding member for each of the plurality of types of auxiliary boards, the light-shielding member including the third opening so as to correspond to a position of the light emitter provided on each of the plurality of types of auxiliary boards.

10. The power converter according to any one of claims 4 to 9, wherein the sheet member includes a character (8b) described in a vicinity of the second opening, the character indicating a content displayed by the indicator.

11. The power converter according to any one of claims 4 to 10, wherein the sheet member includes the sheet member for each of the plurality of types of auxiliary boards, the sheet member including the second opening so as to correspond to a position of the indicator provided on each of the plurality of types of auxiliary boards.

## Patentansprüche

1. Stromrichter (100), umfassend:
einen Stromrichterhauptkörper (5) mit einer darin vorgesehenen Steuerplatine (4), wobei der Stromrichterhauptkörper konfiguriert ist, zu ermöglichen, dass mindestens eine von mehreren Arten von Hilfsplatinen (6), die entsprechend Anzeigen (6a) umfassen, daran angebracht sind, sodass eine Funktion hinzugefügt ist;
ein Gehäuse (1), das konfiguriert ist, den Stromrichterhauptkörper aufzunehmen, wobei das Gehäuse eine erste Öffnung (3) umfasst, sodass die mindestens eine der mehreren Arten von Hilfsplatinen freigelegt ist; und
ein transparentes Abdeckungselement (7), das an der ersten Öffnung des Gehäuses angebracht ist; wobei
die erste Öffnung und das transparente Abdeckungselement für die Anzeigen der mehreren Arten von Zusatzplatinen gemeinsam konfiguriert sind, sodass eine Region von irgendeiner der mehreren Arten von Zusatzplatinen, in der eine Anzeige angeordnet ist, abgedeckt ist, auch wenn die irgendeine der mehreren Arten von Zusatzplatinen auf dem Stromrichterhauptkörper vorgesehen ist.

2. Stromrichter nach Anspruch 1, wobei das transparente Abdeckungselement in der ersten Öffnung abnehmbar vorgesehen ist.

3. Stromrichter nach Anspruch 1 oder 2, ferner umfassend:
eine Bedieneinheit (2), die konfiguriert ist, eine Eingabeoperation zum Steuern des Stromrichterhauptkörpers zu empfangen; wobei
die erste Öffnung an einer Fläche (1a) des Gehäuses angeordnet ist, an der die Bedieneinheit vorgesehen ist.

4. Stromrichter nach einem der Ansprüche 1 bis 3, ferner umfassend:
ein undurchsichtiges Folienelement (8, 18), das an dem transparenten Abdeckungselement angebracht ist; wobei
das Folienelement eine zweite Öffnung (8a, 18a) an einer Position umfasst, welche die Anzeige bei Betrachtung in einer Richtung orthogonal zu einer Fläche des Gehäuses, an der die erste Öffnung vorgesehen ist, überlappt.

5. Stromrichter nach Anspruch 4, wobei das Folienelement ein Dichtungselement (8, 18) umfasst, das an dem transparenten Abdeckungselement befestigt ist.

6. Stromrichter nach Anspruch 4 oder 5, wobei das Folienelement (8) an einer Fläche (7a) des transparenten Abdeckungselements auf einer Seite, die einer Hilfsplatinenseite entgegengesetzt ist, angebracht ist.

7. Stromrichter nach Anspruch 6, wobei
die Anzeige einen Lichtemitter (6a) umfasst, der konfiguriert ist, Licht in Richtung des transparenten Abdeckungselements zu emittieren;
der Stromrichter ferner ein Lichtabschirmelement (9) umfasst, das zwischen dem transparenten Abdeckungselement und der mindestens einen der mehreren Arten von Hilfsplatinen vorgesehen ist; und
das Lichtabschirmelement eine dritte Öffnung (9a) an einer Position umfasst, welche die zweite Öffnung des Folienelements bei Betrachtung in der Richtung orthogonal zu der Fläche des Gehäuses, auf der die erste Öffnung vorgesehen ist, überlappt.

8. Stromrichter nach Anspruch 7, wobei das transparente Abdeckungselement einen Halter (7b) umfasst, der konfiguriert ist, das Lichtabschirmelement auf der Hilfsplatinenseite zu halten.

9. Stromrichter nach Anspruch 7 oder 8, wobei das Lichtabschirmelement das Lichtabschirmelement für jede der mehreren Arten von Hilfsplatinen umfasst und das Lichtabschirmelement die dritte Öffnung umfasst, sodass sie einer Position des Lichtemitters entspricht, der auf jeder der mehreren Arten von Hilfsplatinen vorgesehen ist.

10. Stromrichter nach einem der Ansprüche 4 bis 9, wobei das Folienelement einen Schriftzug (8b) umfasst, der in einer Nähe der zweiten Öffnung beschrieben ist, wobei der Schriftzug einen Inhalt angibt, der von der Anzeige angezeigt wird.

11. Stromrichter nach einem der Ansprüche 4 bis 10, wobei das Folienelement das Folienelement für jede der mehreren Arten von Hilfsplatinen umfasst und das Folienelement die zweite Öffnung umfasst, sodass sie einer Position der Anzeige entspricht, die auf jeder der mehreren Arten von Hilfsplatinen vorgesehen ist.

## Revendications

1. Convertisseur de puissance (100) comprenant :
un corps principal de convertisseur de puissance (5) ayant un tableau de contrôle (4) prévu dans ce dernier, le corps principal de convertisseur de puissance étant configuré pour permettre à au moins l'un d'une pluralité de types de tableaux auxiliaires (6) comprenant respectivement des indicateurs (6a), d'être monté sur ce dernier de sorte qu'une fonction est ajoutée à ce dernier ;
un boîtier (1) configuré pour loger le corps principal de convertisseur de puissance, le boîtier comprenant une première ouverture (3) afin d'exposer le au moins un de la pluralité de types de tableaux auxiliaires ; et
un élément de couvercle transparent (7) fixé à la première ouverture du boîtier ; dans lequel :
la première ouverture et l'élément de couvercle transparent sont configurés pour que les indicateurs de la pluralité de types de tableaux auxiliaires en commun recouvrent une région de l'un quelconque de la pluralité de types de tableaux auxiliaires dans lequel un indicateur est agencé même lorsque l'un quelconque de la pluralité de types de tableaux auxiliaires est prévu sur le corps principal de convertisseur de puissance.

2. Convertisseur de puissance selon la revendication 1, dans lequel l'élément de couvercle transparent est prévu, de manière détachable, dans la première ouverture.

3. Convertisseur de puissance selon la revendication 1 ou 2, comprenant en outre :
une unité opérationnelle (2) configurée pour recevoir une opération d'entrée afin de commander le corps principal de convertisseur de puissance ; dans lequel :
la première ouverture est agencée sur une surface (1a) du boîtier sur lequel l'unité opérationnelle est prévue.

4. Convertisseur de puissance selon l'une quelconque des revendications 1 à 3, comprenant en outre :
un élément de feuille opaque (8, 18) fixé sur l'élément de couvercle transparent ; dans lequel :
l'élément de feuille comprend une deuxième ouverture (8a, 18a) dans une position qui recouvre l'indicateur, comme observé dans une direction orthogonale à une surface du boîtier sur laquelle la première ouverture est prévue.

5. Convertisseur de puissance selon la revendication 4, dans lequel l'élément de feuille comprend un élément formant joint d'étanchéité (8, 18) fixé sur l'élément de couvercle transparent.

6. Convertisseur de puissance selon la revendication 4 ou 5, dans lequel l'élément de feuille (8) est fixé sur une surface (7a) de l'élément de couvercle transparent sur un côté opposé à un côté de tableau auxiliaire.

7. Convertisseur de puissance selon la revendication 6, dans lequel :
l'indicateur comprend un émetteur de lumière (6a) configuré pour émettre de la lumière vers l'élément de couvercle transparent ;
le convertisseur de puissance comprend en outre un élément de protection contre la lumière (9) prévu entre l'élément de couvercle transparent et le au moins un de la pluralité de types de tableaux auxiliaires ; et
l'élément de protection contre la lumière comprend une troisième ouverture (9a) dans une position qui recouvre la deuxième ouverture de l'élément de feuille, comme observé dans la direction orthogonale à la surface du boîtier sur laquelle la première ouverture est prévue.

8. Convertisseur de puissance selon la revendication 7, dans lequel l'élément de couvercle transparent comprend un support (7b) configuré pour maintenir l'élément de protection contre la lumière sur le côté du tableau auxiliaire.

9. Convertisseur de puissance selon la revendication 7 ou 8, dans lequel l'élément de protection contre la lumière comprend l'élément de protection contre la lumière pour chacun de la pluralité de types de tableaux auxiliaires, l'élément de protection contre la lumière comprenant la troisième ouverture afin de correspondre à une position de l'émetteur de lumière prévu sur chacun de la pluralité de types de tableaux auxiliaires.

10. Convertisseur de puissance selon l'une quelconque des revendications 4 à 9, dans lequel l'élément de feuille comprend un caractère (8b) décrit à proximité de la deuxième ouverture, le caractère indiquant un contenu affiché par l'indicateur.

11. Convertisseur de puissance selon l'une quelconque des revendications 4 à 10, dans lequel l'élément de feuille comprend l'élément de feuille pour chacun de la pluralité de types de tableaux auxiliaires, l'élément de feuille comprenant la deuxième ouverture afin de correspondre à une position de l'indicateur prévu sur chacun de la pluralité de types de tableaux auxiliaires.
